# EUROPÄISCHE PATENTANMELDUNG

(11) **EP 0 716 314 A1**
(43) Veröffentlichungstag der Anmeldung: **12.06.1996**
(21) Anmeldenummer: 95203289.4
(22) Anmeldetag: 29.11.1995
(51) Int. Cl.: G01R 33/3415

(54) **MR-Verfahren zur Bestimmung der Kernmagnetisierungsverteilung mit einer Oberflächenspulen-Anordnung**

(30) Priorität: 10.12.1994 DE 4444061
(71) Anmelder: Philips Patentverwaltung GmbH, 22335 Hamburg (DE); Philips Electronics N.V., 5621 BA Eindhoven (NL)
(72) Erfinder: Kuhn, Michael, Dr., c/o Philips, D-22335 Hamburg (DE)
(74) Vertreter: Hartmann, Heinrich, Dipl.-Ing.

(57) **Zusammenfassung**

Die Erfindung betrifft ein MR-Verfahren zur Bestimmung der Kernmagnetisierungsverteilung in einem Untersuchungsbereich, bei dem mit Hilfe einer mindestens zwei Oberflächenspulen enthaltenden Oberflächenspulen-Anordnung mit örtlich inhomogener Empfindlichkeit Teilbild-Daten gewonnen werden, aus denen durch gewichtete Summierung MR-Überlagerungsbilder gebildet werden. Dabei wird eine möglichst Artefakt-freie Darstellung von MR-Überlagerungsbildern dadurch erreicht, daß die Daten mindestens eines mit Hilfe einer Oberflächenspule gewonnenen Teilbildes mit einer weiteren Wichtungsfunktion multipliziert werden derart, daß Bereiche des Teilbildes mit Artefakten schwächer gewichtet werden als Bereiche ohne Artefakte.

## Beschreibung

Die Erfindung betrifft ein MR-Verfahren zur Bestimmung der Kernmagnetisierungsverteilung in einem Untersuchungsbereich, bei dem mit Hilfe einer mindestens zwei Oberflächenspulen enthaltenden Oberflächenspulen-Anordnung mit örtlich inhomogener Empfindlichkeit Teilbild-Daten gewonnen werden, aus denen durch gewichtete Summierung MR-Überlagerungsbilder gebildet werden.

Aus der deutschen Patentanmeldung mit dem Aktenzeichen P 44 27 429.7-33 gilt als Stand der Technik, mit je einer Oberflächenspule Teilbild-Daten für je ein Teilbild zu erfassen und diese Teilbilder durch gewichtete Summierung zu einem MR-Überlagerungsbild (oder Gesamtbild) zu kombinieren.

Die Bestimmung der Kernmagnetisierungsverteilung in einem Untersuchungsbereich mittels einer aus mindestens zwei, in der Praxis aber meist aus mehr als zwei Oberflächenspulen bestehenden Oberflächenspulen-Anordnung hat den Vorteil, daß das Signal/Rauschverhältnis wesentlich besser ist als bei Spulen, die Kernresonanzsignale aus dem gesamten Untersuchungsbereich empfangen können. Nachteilig bei diesem Verfahren ist allerdings, daß Artefakte, die nur in Teilbildern vorhanden sind, bei der Kombination aller Teilbilder zum Gesamtbild den artefaktfreien Teilbildern überlagert werden und im Gesamtbild erscheinen.

Artefakte, beispielsweise Bewegungsartefakte beruhen oft auf der lokalen Bewegung von anatomischen Strukturen, z.B. des (hellen) Fetts der Bauchdecke bei Atmung, auf der Pulsation großer Blutgefäße, oder der Tatsache, daß "frische" Magnet-Spins in (an sich stationäre) Gefäße innerhalb der abgebildeten Schicht eingeströmt sind. Bei Fourier-Verfahren führt dies je nach Frequenz der Bewegung zu durchgehenden oder aus periodischen Wiederholungen ("Geistern") des bewegten Objekts bestehenden Streifen durch die betroffenen Bildpunkte quer über das Bild. Diese Streifen überdecken auch weit entfernte Bereiche, und einzelne "Geister" können (etwa in der Leber) Pathologien (Metastasen) vortäuschen oder deren Kontrast kompensieren (wenn ein heller Artefakt auf eine signalarme Metastase gleicher Größe fällt).

Der vorliegenden Erfindung liegt die Aufgabe zugrunde, ein Verfahren der eingangs genannten Art derart weiterzugestalten, daß das MR-Überlagerungsbild möglichst frei von Artefakten ist.

Diese Aufgabe wird erfindungsgemäß dadurch gelöst, daß die Daten mindestens eines mit Hilfe einer Oberflächenspule gewonnenen Teilbildes mit einer weiteren Wichtungsfunktion multipliziert werden derart, daß Bereiche des Teilbildes mit Artefakten schwächer gewichtet werden als Bereiche ohne Artefakte.

Bei dem bekannten Verfahren wird jedes Teilbild mit einem bestimmten Gewichtsfaktor multipliziert, und danach werden alle Teilbilder zum MR-Überlagerungsbild überlagert. Eine Berücksichtigung von Artefakten oder eine Darstellung einzelner Teilbilder vor der Überlagerung erfolgt dabei nicht. Beim erfindungsgemäßen Verfahren wird mindestens ein Teilbild mit einer weiteren Wichtungsfunktion multipliziert. Dadurch können bei geeigneter Wahl der Wichtungsfunktion Bereiche eines Teilbildes, in denen beispielsweise aufgrund der Inhomogenität der Empfindlichkeit der zugehörigen Oberflächenspule die Intensität von Bildpunkten nicht auf einem gemessenen Signal, sondern auf einem Artefakt beruht, schwächer gewichtet werden als Bereiche, die nahe an der messenden Oberflächenspule liegen und ein starkes Meßsignal liefern können. Wird in einem Teilbild ein Artefakt erkannt - beispielsweise automatisch oder bei Betrachtung des Teilbildes durch den Arzt - so kann die Wichtungsfunktion für dieses Teilbild entsprechend angepaßt werden, so daß eine störende Überlagerung der Artefakte in andere Teilbilder vermieden wird.

In einer vorteilhaften Weiterbildung der Erfindung entspricht die Wichtungsfunktion der Empfindlichkeitsfunktion oder einer Potenz der Empfindlichkeitsfunktion der Oberflächenspule, deren Teilbild-Daten mit dieser Wichtungsfunktion multipliziert werden. Die Empfindlichkeitsfunktion einer Oberflächenspule kann beispielsweise aus theoretischen (Biot-Savart-) Rechnungen oder aus Messungen an einem homogenen Phantomkörper bekannt sein. Mit steigender Potenz der Empfindlichkeitsfunktion als Wichtungsfunktion werden Bildpunkte in immer größerer Entfernung von der Spule immer stärker unterdrückt. Die Intensität von Bildpunkten, für die die Empfindlichkeit der Oberflächenspule stark abgefallen ist, wird so stark reduziert, daß ihre Überlagerung in andere Teilbilder nach der Kombination der Teilbilder im Gesamtbild nicht mehr stört und somit auch keine Artefakte in das Gesamtbild überlagert werden können.

Eine weitere Ausgestaltung sieht vor, daß Bereiche eines MR-Überlagerungsbildes nur durch Teilbild-Daten gebildet werden, die von einer oder mehreren Oberflächenspulen gewonnen wurden, die diesen ausgewählten Bereich mit dem besten Signal/Rauschverhältnis erfaßt haben. Soll bei der Betrachtung eines Gesamtbildes ein bestimmter Bereich besonders deutlich dargestellt werden, so werden möglichst viele oder alle Überlagerungsbeiträge anderer Teilbilder, die durch Artefakte in diesem Bereich Bildteile abdecken können, bei der Darstellung dieses Bereichs unterdrückt, während die anderen Bereiche des Gesamtbildes als Überlagerung aller Teilbilder dargestellt werden.

Ein Nachteil bei der Erzeugung von MR-Bildern mit Hilfe einer Oberflächenspulen-Anordnung besteht darin, daß die Empfindlichkeit (die - ortsabhängige - Empfindlichkeit einer MR-Spule ist definiert als der Quotient aus der magnetischen Induktion an einem bestimmten Ort und aus dem Strom in der Spule, der diese magnetische Induktion an diesem Ort hervorruft) örtlich inhomogen ist, d.h. davon abhängt, wo im Untersuchungsbereich das MR-Signal auftritt. Um die ortsabhängigen Empfindlichkeitunterschiede auszugleichen, ist deshalb in einer weiteren Ausgestaltung der Erfindung vorgesehen, daß mit Hilfe einer Körperspulen-Anordnung mit örtlich näherungsweise homogener Empfindlichkeit Hilfswerte abgeleitet werden zur Korrektur der Teilbild-Daten der Oberflächenspulen.

Eine MR-Anordnung zur Durchführung des erfindungsgemäßen Verfahrens, umfassend
a) eine mindestens zwei Spulen umfassende Oberflächenspulen-Anordnung
b) Verarbeitungsmittel zur Erzeugung von MR-Bildern aus den von der Oberflächenspulen-Anordnung empfangenen MR-Signalen
c) programmierbare Steuermittel zum Steuern des zeit lichen Verlaufs der auf den Untersuchungsbereich einwirkenden Magnetfelder und der MR-Signalverarbeitung,
ist so gestaltet, daß weitere Steuermittel zum Steuern der Wichtungsfunktionen der Teilbild-Daten vorgesehen sind. In weiterer Ausgestaltung der Erfindung ist dabei vorgesehen, daß eine Körperspulen-Anordnung mit örtlich zumindest näherungsweise homogener Empfindlichkeit zur Erfassung von Daten für die Berechnung von Hilfswerten zur Korrektur von Teilbild-Daten vorgesehen ist.

Die Erfindung wird nachstehend anhand der Zeichnung näher erläutert. Es zeigen:
- Fig. 1: ein Blockschaltbild eines MR-Untersuchungsgerätes, das die Erfindung beinhalten kann, und
- Fig. 2: eine Darstellung einer Körperspulen-Anordnung und einer Oberflächenspulen-Anordnung.

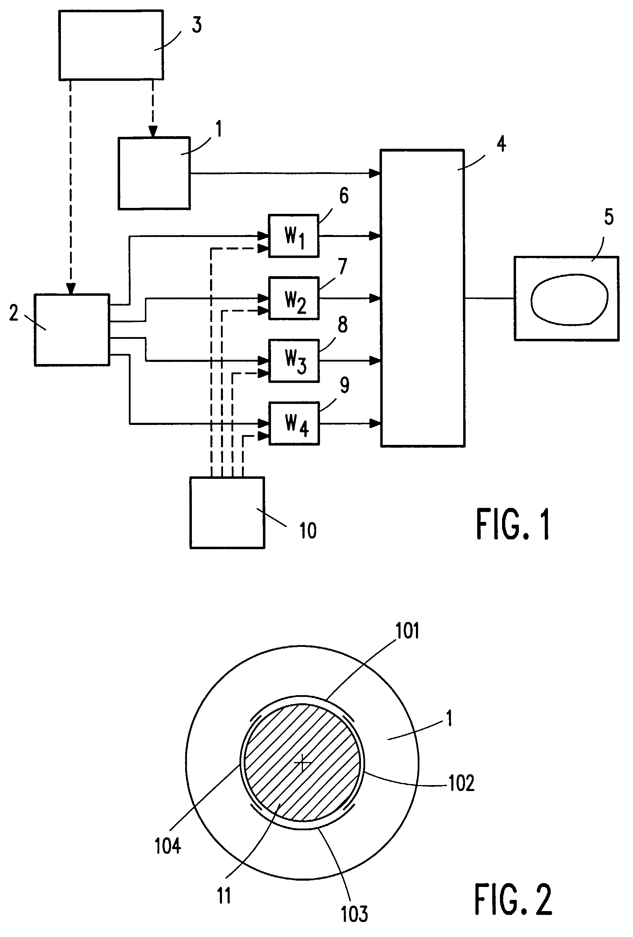

In dem in Fig. 1 schematisch dargestellten Blockschaltbild ist mit 1 eine Körperspulen-Anordnung bezeichnet, die üblicherweise zylinderförmig ausgestaltet ist und bei der MR-Untersuchung den Körper des Patienten auf einer bestimmten Länge umschließt. Eine aus mehreren Oberflächenspulen bestehende Oberflächenspulen-Anordnung ist mit 2 bezeichnet. Diese beiden Spulen-Anordnungen 1 und 2 werden im Sende- und Empfangsbetrieb von der Steuereinheit 3 gesteuert.

Eine Empfängereinheit 4 enthält für jede Spule der Oberflächenspulen-Anordnung 2 und für die Körperspulen-Anordnung 1 je einen Kanal, in dem das von der jeweiligen Spule empfangene MR-Signal verstärkt, in einen niedrigeren Frequenzbereich transponiert und digitalisiert wird und in dem aus den digitalisierten MR-Signalen jeweils ein MR-Bild rekonstruiert werden kann. Die in der Empfänger- und Verarbeitungseinheit 4 erzeugten MR-Bilder sind auf einem Monitor 5 darstellbar.

Von den Spulen-Anordnungen 1 und 2 ist jeweils nur eine wirksam. Wenn die MR-Signale von der Körperspulen-Anordnung 1 empfangen werden sollen, werden die Spulen der Oberflächenspulen-Anordnung 2 durch die Steuereinheit 3 verstimmt, und wenn mit der Oberflächenspulen-Anordnung 2 empfangen werden soll, wird die Körperspulen-Anordnung 1 verstimmt. Dadurch sind diese Spulen-Anordnungen induktiv voneinander entkoppelt.

Hinsichtlich weiterer Verfahrensschritte eines MR-Verfahrens zur Bestimmung der Kernmagnetisierungsverteilung wird auf den genannten Stand der Technik verwiesen.

In jedem Kanal von der Oberflächenspulen-Anordnung 2 zur Empfängereinheit 4 ist eine Wichtungseinheit 6...9 vorhanden, mit der die Teilbild-Daten in jedem Kanal mit einer Wichtungsfunktion W₁ ... W₄ multipliziert werden können. Beeinflußt werden können diese Wichtungsfunktionen W₁ ... W₄ über eine Wichtungssteuerung 10.

Fig. 2 zeigt die räumliche Lage der Körperspulen-Anordnung 1, bei der es sich z.B. um eine Spule vom Bird-Cage-Typ handeln kann, sowie die aus mehreren (im Beispiel vier) einzelnen Oberflächenspulen 101...104 bestehende Oberflächenspulen-Anordnung. Die vier Oberflächenspulen 101 bis 104 können auf einem nicht näher dargestellten flexiblen Träger angeordnet sein, der um den Patienten 11 herum gewickelt wird. Die Spulen sind dabei so auf dem Träger angeordnet, daß sie sich in einem definierten Bereich überlappen, so daß sich eine gute Entkopplung zwischen diesen Oberflächenspulen ergibt.

Wenn die Empfindlichkeitsprofile der Oberflächenspulen bekannt sind, so können diese als Wichtungsfunktionen W₁ ... W₄ benutzt werden. Die Intensität von Bildpunkten, die weiter von einer Oberflächenspule entfernt sind, wird verringert im Vergleich zu näher bei einer Oberflächenspule liegenden Bildpunkten. Soll dieser Effekt noch verstärkt werden, so kann in jedem Kanal statt der Empfindlichkeitsfunktion auch deren Quadrat oder eine höhere Potenz als Wichtungsfunktion verwendet werden.

Die Wichtungssteuerung 10 kann dabei auch eine Schnittstelle zum Benutzer aufweisen, über die der Benutzer beispielsweise die Potenz der Wichtungsfunktion in jedem Kanal getrennt verändern kann. Vorteilhafterweise kann die Wichtungsfunktion auch beliebig über die Wichtungssteuerung 10 modifiziert werden. Dadurch kann verhindert werden, daß Bereiche des Gesamtbildes, die in allen Teilbildern aufgrund großer Entfernung von den Oberflächenspulen schwach gewichtet wurden, keine Bildinformationen mehr tragen, indem beispielsweise die Wichtung derartiger Bereiche in den Teilbildern angehoben wird.

In einer Ausgestaltung des Verfahrens werden von der Empfänger- und Verarbeitungseinheit 4 zunächst alle Teilbilder einzeln nacheinander auf dem Monitor 5 dargestellt. Der Benutzer kann danach die Wichtungsfunktion jedes einzelnen Teilbildes derart auswählen (z.B. aus einem angebotenen Wichtungsfunktionensatz) oder derart verändern, daß Bereiche eines Teilbildes, in denen Artefakte auftreten, schwächer gewichtet werden als Bereiche ohne Artefakte.

Trennlinien zwischen Bereichen mit und ohne Artefakte in einem Teilbild können entweder vom Benutzer eingefügt oder automatisch bei Kenntnis der Empfindlichkeitsfunktion der betreffenden Oberflächenspule vorgegeben werden. Dabei wird als Trennlinie idealerweise eine Linie gewählt, auf der die Oberflächenspule überall eine gleich große Empfindlichkeit aufweist. Vorteilhafterweise weist die Wichtungsfunktion keinen Funktionssprung an Trennlinien auf, sondern ist eine stetige, an die Trennlinie angepaßte Funktion, da sonst im dargestellten Gesamtbild störende Trennlinien sichtbar bleiben würden.

Mit Hilfe einer weiteren, nicht dargestellten Benutzerschnittstelle, beispielsweise einer Computermaus zur Cursorpositionierung oder zur Verschiebung eines Ausschnittfensters auf dem Bildschirm, kann der Benutzer einen Bereich des Gesamtbildes, den er besonders genau betrachten möchte, auswählen. Die Empfängereinheit 4 wählt danach aus den einzelnen Oberflächenspulen diejenige aus, die den gewünschten Bildbereich mit dem besten Signal/Rauschverhältnis erfaßt hat und/oder überprüft, ob dieses Signal/Rauschverhältnis hinreichend groß, beispielsweise größer als ein vorgegebener Schwellwert ist. Der gewünschte Bildbereich wird dann nur vom Teilbild der ausgewählten Oberflächenspule dargestellt, während der restliche Bereich des Gesamtbildes als Überlagerung aller Teilbilder dargestellt wird. Dem genauer betrachteten Bildbereich können somit keine Artefakte aus anderen Teilbildern überlagert sein.

## Patentansprüche

1. MR-Verfahren zur Bestimmung der Kernmagnetisierungsverteilung in einem Untersuchungsbereich (11), bei dem mit Hilfe einer mindestens zwei Oberflächenspulen (101...104) enthaltenden Oberflächenspulen-Anordnung (2) mit örtlich inhomogener Empfindlichkeit Teilbild-Daten gewonnen werden, aus denen durch gewichtete Summierung MR-Überlagerungsbilder gebildet werden,
dadurch gekennzeichnet, daß die Daten mindestens eines mit Hilfe einer Oberflächenspule (101...104) gewonnenen Teilbildes mit einer weiteren Wichtungsfunktion multipliziert werden derart, daß Bereiche des Teilbildes mit Artefakten schwächer gewichtet werden als Bereiche ohne Artefakte.

2. MR-Verfahren nach Anspruch 1,
dadurch gekennzeichnet, daß die Wichtungsfunktion der Empfindlichkeitsfunktion oder einer Potenz der Empfindlichkeitsfunktion der Oberflächenspule (101...104) entspricht, deren Teilbild-Daten mit dieser Wichtungsfunktion multipliziert werden.

3. MR-Verfahren nach einem der vorhergehenden Ansprüche,
dadurch gekennzeichnet, daß Bereiche eines MR-Überlagerungsbildes nur durch Teilbild-Daten gebildet werden, die von einer oder mehreren Oberflächenspulen (101...104) gewonnen wurden, die diese ausgewählten Bereiche mit dem besten Signal/Rauschverhältnis erfaßt haben.

4. MR-Verfahren nach einem der vorhergehenden Ansprüche,
dadurch gekennzeichnet, daß mit Hilfe einer Körperspulen-Anordnung (1) mit örtlich näherungsweise homogener Empfindlichkeit Hilfswerte abgeleitet werden zur Korrektur der Teilbild-Daten der Oberflächenspulen (101...104).

5. MR-Anordnung zur Durchführung des Verfahrens nach Anspruch 1, umfassend
a) eine mindestens zwei Spulen (101...104) umfassende Oberflächenspulen-Anordnung (2)
b) Verarbeitungsmittel (4) zur Erzeugung von MR-Bildern aus den von der Oberflächenspulen-Anordnung (101...104) empfangenen MR-Signalen
c) programmierbare Steuermittel (3) zum Steuern des zeitlichen Verlaufs der auf den Untersuchungsbereich (11) einwirkenden Magnetfelder und der MR-Signalverarbeitung,
dadurch gekennzeichnet,
daß weitere Steuermittel (10) zum Steuern der Wichtungsfunktionen der Teilbild-Daten vorgesehen sind.

6. MR-Anordnung nach Anspruch 5,
dadurch gekennzeichnet, daß eine Körperspulen-Anordnung (1) mit örtlich zumindest näherungsweise homogener Empfindlichkeit zur Erfassung von Daten für die Berechnung von Hilfswerten zur Korrektur von Teilbild-Daten vorgesehen ist.
